# DEMANDE DE BREVET EUROPEEN

(11) **EP 3 474 335 A1**
(43) Date de publication de la demande: **24.04.2019**
(21) Numéro de dépôt: 18201647.7
(22) Date de dépôt: 19.10.2018
(51) Int. Cl.: H01L 31/18, H01L 31/0288, H01L 31/068, H01L 21/225, H01L 31/0236, H01L 31/0216, H01L 31/0368

(54) **PROCEDE DE FABRICATION D'UNE CELLULE PHOTOVOLTAÏQUE**

(30) Priorité: 23.10.2017 FR 1759980
(71) Demandeur: Commissariat à l'Énergie Atomique et aux Énergies Alternatives, 75015 Paris (FR)
(72) Inventeur: ENJALBERT, Nicolas, 81100 BURLATS (FR); PICARD, Erwann, 73000 CHAMBERY (FR)
(74) Mandataire: GIE Innovation Competence Group

(57) **Abrégé**

Ce procédé comporte les étapes successives :
a) prévoir un substrat (1) en silicium cristallin dopé de type p, comprenant :
- une première surface (10) et une deuxième surface (11) opposée,
- au moins une surface latérale (12) reliant les première et deuxième surfaces (10, 11) ;

b) former une couche de verre phosphosilicate (2, 20, 21) sur les première et deuxième surfaces (10, 11) ainsi que sur ladite au moins une surface latérale (12) du substrat (1) ; l'étape b) étant exécutée à une température comprise entre 700°C et 900°C, sous une atmosphère comportant un précurseur contenant du phosphore ;
c) appliquer un recuit thermique à la couche de verre phosphosilicate (2, 20, 21) formée à l'issue de l'étape b) ; l'étape c) étant exécutée à une température comprise entre 850°C et 900°C sous une atmosphère inerte ;
d) former une couche antireflet (3) sur la couche de verre phosphosilicate (20) s'étendant sur la première surface (10) du substrat (1) ;
e) retirer la couche de verre phosphosilicate (21) s'étendant sur la deuxième surface (11) et sur ladite au moins une surface latérale (12) du substrat (1), tout en conservant la couche de verre phosphosilicate (20) s'étendant sur la première surface (10) du substrat (1).

## Description

### Domaine technique

L'invention se rapporte au domaine technique des cellules photovoltaïques de silicium. Plus précisément, l'invention concerne la fabrication de cellules photovoltaïques comportant une jonction p-n sur une seule et unique face (i.e. la face avant) de la cellule photovoltaïque.

Dans le cas d'un substrat de silicium cristallin dopé de type n, la cellule photovoltaïque comporte une zone semi-conductrice superficielle dopée de type p (classiquement par la présence d'atomes de bore). Dans le cas d'un substrat de silicium cristallin dopé de type p, la cellule photovoltaïque comporte une zone semi-conductrice superficielle dopée de type n (classiquement par la présence d'atomes de phosphore).

### État de la technique antérieure

La zone semi-conductrice superficielle dopée de type p est classiquement formée par diffusion des atomes de bore issus d'un verre borosilicate (ci-après BSG) formé sur la face avant du substrat. De la même façon, la zone semi-conductrice superficielle dopée de type n est classiquement formée par diffusion des atomes de phosphore issus d'un verre phosphosilicate (ci-après PSG) formé sur la face avant du substrat.

Le BSG et le PSG sont classiquement formés dans un four de diffusion des dopants avec des tubes en quartz. De tels fours permettent une cadence de production élevée tout en gardant un procédé de haute qualité à coût réduit. Au cours de la diffusion des dopants, le substrat de silicium est placé sur un support en quartz où les faces avant et arrière, ainsi que les quatre faces latérales du substrat, sont exposés à la source de dopants (par exemple POCl₃ pour le phosphore). Ainsi, la diffusion de dopants s'effectue tout autour du substrat. Or, comme évoqué précédemment, l'invention vise la fabrication de cellules photovoltaïques comportant une jonction p-n sur une seule et unique face (i.e. la face avant) de la cellule photovoltaïque. Il est donc nécessaire d'isoler la face avant des autres faces du substrat.

Par ailleurs, le BSG et le PSG sont ensuite classiquement supprimés puis des couches de passivation sont formées sur les faces avant et arrière du substrat. Les étapes de formation puis de suppression du BSG (ou du PSG) sont coûteuses en temps d'opération.

### Isolation de la face avant

Un premier procédé de fabrication connu de l'état de la technique, notamment du document S.R. Reddy et al., « Development of Laser Edge Isolation Process for Industrial Solar Cells », International Journal of Innovative Research in Science, Engineering and Technology, 2 (10), 2013, comporte une étape consistant à isoler la face avant du substrat par l'application d'un faisceau laser sur la périphérie du substrat. Un tel premier procédé de l'état de la technique n'est pas entièrement satisfaisant dans la mesure où l'irradiation laser affecte les performances de la cellule photovoltaïque.

Un deuxième procédé de fabrication connu de l'état de la technique, notamment des documents de J. Rentsch et al, « Single side etching - Key technology for industrial high efficiency processing », 23rd European Photovoltaïc Solar Energy Conference, 2008, et de E. Cornagliotti et al, « Intégration of inline single-side wet emitter etch in PERC cell manufacturing», Energy Procedia 27, 624-630, 2012, comporte une étape consistant à isoler la face avant du substrat par une gravure chimique, appelée « *Single Side Etching* » en langue anglaise, sur la seule face arrière du substrat. Une telle gravure chimique comporte classiquement trois bains successifs : HF/HNO₃, KOH et HF/HCl. Un tel deuxième procédé de l'état de la technique n'est pas entièrement satisfaisant dans la mesure où la forte consommation d'eau et d'espèces chimiques rend ce procédé coûteux, en particulier le recyclage de HNO₃.

Un troisième procédé de fabrication connu de l'état de la technique comporte une étape consistant à isoler la face avant par un masquage sacrificiel de la face arrière. Une couche de barrière à la diffusion est ainsi formée sur la face arrière du substrat avant une étape de diffusion des dopants. Un tel troisième procédé de l'état de la technique n'est pas entièrement satisfaisant dans la mesure où il engendre plusieurs étapes supplémentaires, augmentant par là-même le temps d'opération (dépôt puis suppression de la couche barrière) ainsi que les risques de contamination du substrat.

### Conservation du PSG

Il est connu de l'état de la technique, notamment du document de C.-H. Du et al., « A well-controlled PSG layer on silicon solar cells against potential induced dégradation », ECS Journal of Solid State Science and Technology, 4 (3), p.97-100 (2015), que le fait de conserver le verre phosphosilicate permet d'améliorer les performances de la cellule photovoltaïque en termes de PID (« *Potential Induced Dégradation* » en langue anglaise). L'étape de diffusion est exécutée pour différentes températures : 821°C, 831°C et 841°C. Toutefois, les épaisseurs du PSG sont trop importantes pour garantir de bonnes propriétés optiques et de passivation.

Il est à noter que l'isolation de la face avant du substrat est effectuée par application d'un faisceau laser dans ce document, affectant les performances de la cellule photovoltaïque, comme évoqué précédemment.

### Exposé de l'invention

L'invention vise à remédier en tout ou partie aux inconvénients précités. A cet effet, l'invention a pour objet un procédé de fabrication d'une cellule photovoltaïque, comportant les étapes successives :
a) prévoir un substrat en silicium cristallin dopé de type p, comprenant :
   - une première surface et une deuxième surface opposée,
   - au moins une surface latérale reliant les première et deuxième surfaces ;
b) former une couche de verre phosphosilicate sur les première et deuxième surfaces ainsi que sur ladite au moins une surface latérale du substrat ; l'étape b) étant exécutée à une température comprise entre 700°C et 900°C, sous une atmosphère comportant un précurseur contenant du phosphore ;
c) appliquer un recuit thermique à la couche de verre phosphosilicate formée à l'issue de l'étape b) ; l'étape c) étant exécutée à une température comprise entre 850°C et 900°C sous une atmosphère inerte ;
d) former une couche antireflet sur la couche de verre phosphosilicate s'étendant sur la première surface du substrat ;
e) retirer la couche de verre phosphosilicate s'étendant sur la deuxième surface et sur ladite au moins une surface latérale du substrat, tout en conservant la couche de verre phosphosilicate s'étendant sur la première surface du substrat.

Ainsi, un tel procédé selon l'invention permet de conserver le verre phosphosilicate (également connu sous l'acronyme anglo-saxon PSG) s'étendant sur la première surface du substrat grâce aux étapes b) et c) qui améliore ses propriétés optiques et de passivation. En outre, l'étape c) est exécutée à haute température sous atmosphère inerte, ce qui permet de densifier le PSG et améliorer ses propriétés de passivation. Il est alors possible de former la couche antireflet lors de l'étape d) sur le PSG, ce qui simplifie grandement la fabrication de la cellule photovoltaïque. Par ailleurs, l'étape c) permet de diffuser des atomes de phosphore de la couche de PSG vers le substrat.

L'invention a également pour objet un procédé de fabrication d'une cellule photovoltaïque, comportant les étapes successives :
a) prévoir un substrat en silicium cristallin dopé de type n, comprenant :
   - une première surface et une deuxième surface opposée,
   - au moins une surface latérale reliant les première et deuxième surfaces ;
b) former une couche de verre borosilicate sur les première et deuxième surfaces ainsi que sur ladite au moins une surface latérale du substrat ; l'étape b) étant exécutée à une température comprise entre 700°C et 900°C, sous une atmosphère comportant un précurseur contenant du bore ;
c) appliquer un recuit thermique à la couche de verre borosilicate formée à l'issue de l'étape b) ; l'étape c) étant exécutée à une température comprise entre 800°C et 1000°C sous une atmosphère inerte ;
d) former une couche antireflet sur la couche de verre borosilicate s'étendant sur la première surface du substrat ;
e) retirer la couche de verre borosilicate s'étendant sur la deuxième surface et sur ladite au moins une surface latérale du substrat, tout en conservant la couche de verre borosilicate s'étendant sur la première surface du substrat.

Ainsi, un tel procédé selon l'invention permet de conserver le verre borosilicate (également connu sous l'acronyme anglo-saxon BSG) s'étendant sur la première surface du substrat grâce aux étapes b) et c) qui améliore ses propriétés optiques et de passivation. En outre, l'étape c) est exécutée à haute température sous atmosphère inerte, ce qui permet de densifier le BSG et améliorer ses propriétés de passivation. Il est alors possible de former la couche antireflet lors de l'étape d) sur le BSG, ce qui simplifie grandement la fabrication de la cellule photovoltaïque. Par ailleurs, l'étape c) permet de diffuser des atomes de bore de la couche de BSG vers le substrat.

Le concept inventif commun réside dans la conservation de la couche dopante (i.e. le PSG ou le BSG) grâce aux étapes b) et c) au cours de la fabrication de la cellule photovoltaïque.

### Définitions

- Par «cristallin », on entend la forme multicristalline ou la forme monocristalline du silicium, excluant donc le silicium amorphe.
- Par « couche antireflet », on entend une couche qui, de par une épaisseur adaptée, permet de réduire les pertes optiques liées aux réflexions du rayonnement lumineux, et par là-même permet d'optimiser l'absorption du rayonnement lumineux par le substrat.
- Par « atmosphère inerte », on entend une atmosphère non-réactive pour la cellule photovoltaïque.

Le procédé selon l'invention peut comporter une ou plusieurs des caractéristiques suivantes.

Selon une caractéristique de l'invention, l'étape b) est exécutée de sorte que la couche de verre phosphosilicate présente une épaisseur comprise entre 2 nm et 50 nm, de préférence comprise entre 2 nm et 10 nm.

Par « épaisseur », on entend la dimension suivant la normale à la première surface (ou à la deuxième surface) du substrat.

Ainsi, un avantage procuré est de ne pas affecter les propriétés optiques de la cellule photovoltaïque. En particulier, la gamme d'épaisseurs [2-10] nm permet de limiter la non-homogénéité du PSG.

Selon une caractéristique de l'invention, l'étape b) est exécutée de sorte que la couche de verre borosilicate présente une épaisseur comprise entre 2 nm et 150 nm, de préférence comprise entre 2 nm et 10 nm.

Ainsi, un avantage procuré est de ne pas affecter les propriétés optiques de la cellule photovoltaïque. En particulier, la gamme d'épaisseurs [2-10] nm permet de limiter la non-homogénéité du BSG.

Selon une caractéristique de l'invention, la température à laquelle est exécutée l'étape c) est comprise entre 850°C et 920°C.

Selon une caractéristique de l'invention, la température à laquelle est exécutée l'étape b) est comprise entre 750°C et 800°C.

Ainsi, l'étape b) est exécutée à plus basse température que l'état de la technique, ce qui permet de limiter l'épaisseur du PSG (ou du BSG) et sa non-homogénéité.

Selon une caractéristique de l'invention, l'atmosphère inerte sous laquelle est exécutée l'étape c) est un mélange gazeux comportant du diazote N₂ dans une proportion supérieure à 80% en pression partielle.

Ainsi, un avantage procuré est d'obtenir une atmosphère inerte favorable à la densification du PSG ou du BSG.

Selon une caractéristique de l'invention, l'atmosphère sous laquelle est exécutée l'étape b) est un mélange gazeux comportant du dioxygène O₂ dans une proportion inférieure à 10% en pression partielle.

Ainsi, un avantage procuré est d'obtenir une atmosphère favorable à l'obtention d'une faible épaisseur du PSG ou du BSG.

Selon une caractéristique de l'invention, l'étape e) est exécutée par un agent de gravure chimique, et la couche antireflet formée lors de l'étape d) est réalisée dans un matériau formant une barrière à l'agent de gravure chimique.

Ainsi, un avantage procuré est d'utiliser la couche antireflet comme masque non-sacrificiel pour la gravure chimique lorsque le matériau de la couche antireflet forme une barrière totale à l'agent de gravure chimique au sens où ledit matériau est résistant à l'agent de gravure chimique. On s'affranchit alors de la formation d'un masque sacrificiel coûteux en temps d'opération. Le matériau de la couche antireflet peut former une barrière partielle à l'agent de gravure chimique au sens où ledit matériau est plus résistant à l'agent de gravure chimique que le PSG ou le BSG.

Selon une caractéristique de l'invention, l'étape e) est exécutée en plongeant le substrat dans une solution d'acide fluorhydrique HF, présentant un ratio molaire H₂O/HF compris entre 20/1 et 50/1, et pendant une durée comprise entre 10 secondes et 3 minutes.

Ainsi, un avantage procuré par un tel agent de gravure est de ne pas attaquer une couche antireflet classiquement réalisée en nitrure de silicium SiₓN_{y}. En outre, une telle étape e) permet de s'affranchir de toute couche parasite pouvant se former à la deuxième surface du substrat, ce qui permet d'envisager ultérieurement un polissage chimique efficace de la deuxième surface du substrat avec une solution d'hydroxyde de potassium KOH.

De plus, une telle étape e) permet d'envisager d'enchaîner un polissage chimique au sein d'une même enceinte verticale, en utilisant un traitement des substrats par lots (gravure chimique de type « *batch* » en langue anglaise).

Enfin, un tel agent de gravure est moins coûteux que l'acide nitrique HNO₃, complexe à recycler.

Selon une caractéristique de l'invention, l'étape b) est exécutée dans un four de diffusion.

Ainsi, un avantage procuré est d'obtenir une cadence de production élevée tout en gardant un procédé de haute qualité à coût réduit.

Selon une caractéristique de l'invention, la couche antireflet formée lors de l'étape d) est en nitrure de silicium.

Selon une caractéristique de l'invention, le procédé comporte une étape f) consistant à polir chimiquement la deuxième surface du substrat, l'étape f) étant exécutée après l'étape e).

Ainsi, un avantage procuré est d'améliorer les performances de la cellule photovoltaïque, comme évoqué dans les documents de E. Cornagliotti et al, « How much rear side polishing is required ? A study on the impact of rear side polishing in PERC solar cells », 27th European Photovoltaïc Solar Energy Conférence and Exhibition, 2012, et de C. Kranz et al., « Wet chemical polishing for industrial type PERC solar cells », Energy Procedia 38, 243-249, 2013.

Selon une caractéristique de l'invention, l'étape f) est exécutée par un agent de gravure chimique, de préférence l'acide fluorhydrique, et la couche antireflet formée lors de l'étape d) est réalisée dans un matériau résistant à l'agent de gravure chimique, ledit matériau étant de préférence un nitrure de silicium.

Selon une caractéristique de l'invention, l'étape f) est exécutée en plongeant le substrat dans un bain d'hydroxyde de potassium KOH.

Selon une caractéristique de l'invention, l'étape f) est suivie d'une étape consistant à plonger le substrat dans un bain d'acide chlorhydrique HCl.

Ainsi, un avantage procuré est de nettoyer les contaminants engendrés par l'hydroxyde de potassium KOH.

### Brève description des dessins

D'autres caractéristiques et avantages apparaîtront dans l'exposé détaillé de différents modes de réalisation de l'invention, l'exposé étant assorti d'exemples et de références aux dessins joints.
Figures la à le sont des vues schématiques en coupe illustrant des étapes d'un procédé selon l'invention pour la fabrication d'une cellule photovoltaïque de type Al-BSF (« *Aluminium-Back Surface Field*» en langue anglaise).

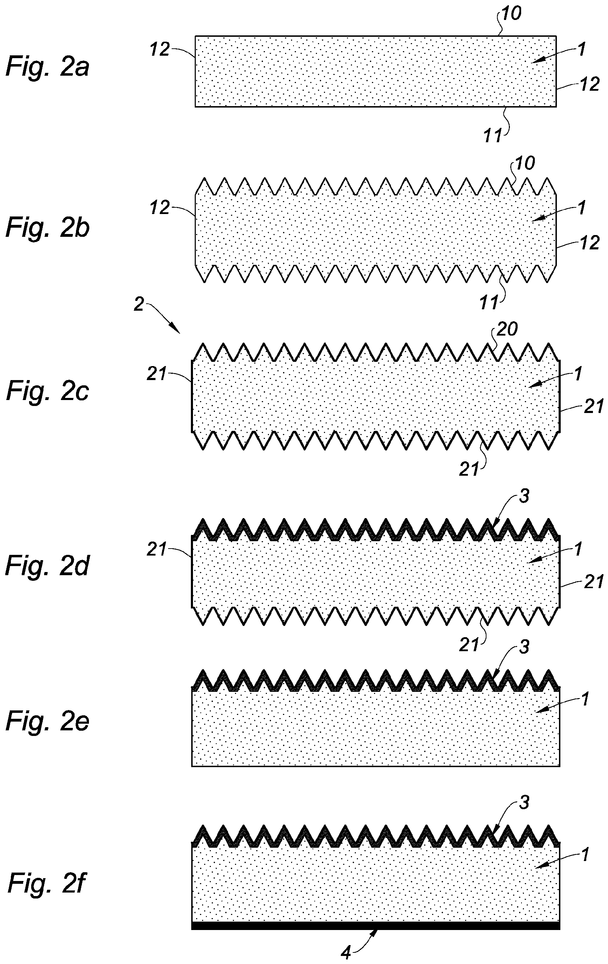

Figures 2a à 2f sont des vues schématiques en coupe illustrant des étapes d'un procédé selon l'invention pour la fabrication d'une cellule photovoltaïque de type PERC (« *Passivated Emitter and Rear Cell*» en langue anglaise).
Les figures ne sont pas représentées à l'échelle pour en simplifier leur compréhension.

### Exposé détaillé des modes de réalisation

Les éléments identiques ou assurant la même fonction porteront les mêmes références pour les différents modes de réalisation, par souci de simplification.

Un objet de l'invention est un procédé de fabrication d'une cellule photovoltaïque, comportant les étapes successives :
a) prévoir un substrat 1 en silicium cristallin dopé de type p, comprenant :
   - une première surface 10 (dite face avant) et une deuxième surface 11 opposée (dite face arrière),
   - au moins une surface latérale 12 (quatre surfaces latérales 12 dans le cas d'un substrat 1 parallélépipédique, dont seulement deux surfaces latérales 12 sont visibles sur les figures) reliant les première et deuxième surfaces 10, 11 ;
b) former une couche de verre phosphosilicate 2 (PSG) sur les première et deuxième surfaces 10, 11 ainsi que sur les quatre surfaces latérales 12 du substrat 1 ; l'étape b) étant exécutée à une température comprise entre 700°C et 900°C, sous une atmosphère comportant un précurseur contenant du phosphore ;
c) appliquer un recuit thermique à la couche de verre phosphosilicate 2 formée à l'issue de l'étape b) ; l'étape c) étant exécutée à une température comprise entre 850°C et 900°C sous une atmosphère inerte ;
d) former une couche antireflet 3 sur la couche de verre phosphosilicate 20 s'étendant sur la première surface 10 du substrat 1 ;
e) retirer la couche de verre phosphosilicate 21 s'étendant sur la deuxième surface 11 et sur les quatre surfaces latérales 12 du substrat 1, tout en conservant la couche de verre phosphosilicate 20 s'étendant sur la première surface 10 du substrat 1.

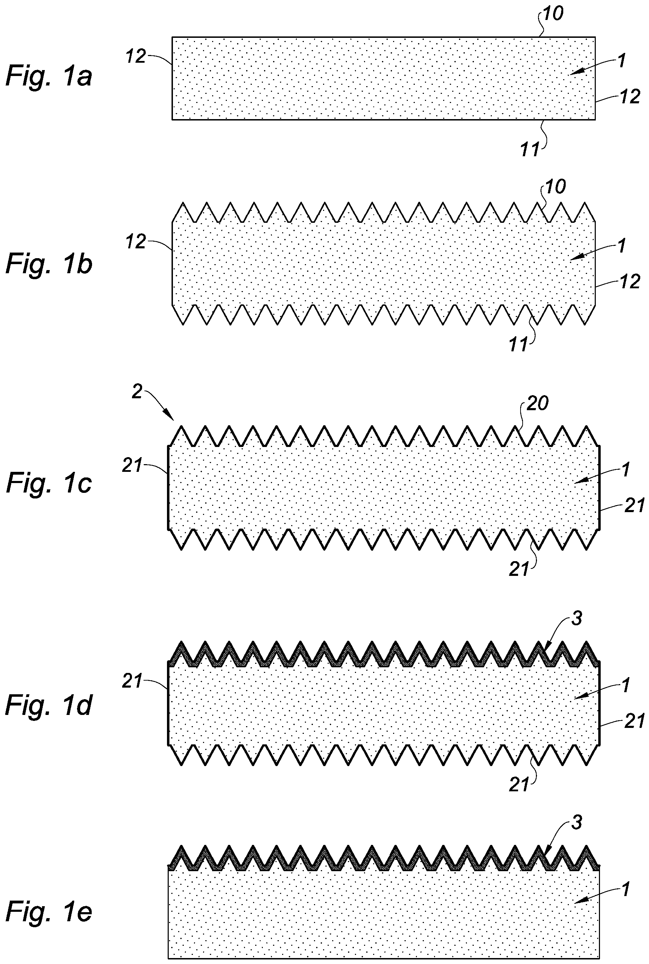

L'étape a) est illustrée aux figures la et 2a. L'étape b) est illustrée aux figures 1c et 2c. L'étape d) est illustrée aux figures 1d et 2d. L'étape e) est illustrée aux figures le et 2e.

### Substrat

Le substrat 1 est avantageusement un substrat 1 en silicium dopé de type p. Le substrat 1 peut être dopé en bore avec une concentration comprise entre 10¹⁵ et 10¹⁷ at.cm⁻³. Le silicium dans lequel est réalisé le substrat 1 peut être monocristallin ou polycristallin.

Le substrat 1 présente préférentiellement une épaisseur strictement inférieure à 250 µm.

Comme illustré aux figures 1b et 2b, l'étape a) comporte avantageusement une étape a₁) consistant à former des motifs de texturation sur les première et deuxième surfaces 10, 11 du substrat 1. Une telle texturation des première et deuxième surfaces 10, 11 du substrat 1 permet une réduction importante du coefficient de réflexion et des pertes optiques dans la cellule photovoltaïque.

Le procédé peut comporter une étape de nettoyage du substrat 1, par exemple en plongeant le substrat 1 dans une solution de HF ou de HCl.

### Formation de la couche de PSG

L'étape b) est avantageusement exécutée de sorte que la couche de verre phosphosilicate 2 présente une épaisseur comprise entre 2 nm et 50 nm, de préférence comprise entre 2 nm et 10 nm. Le précurseur contenant du phosphore peut être liquide ou gazeux. Le précurseur contenant du phosphore est de préférence le trichlorure de phosphoryle POCl₃.

La température à laquelle est exécutée l'étape b) est avantageusement comprise entre 750°C et 800°C.

L'atmosphère sous laquelle est exécutée l'étape b) est un mélange gazeux comportant avantageusement du dioxygène O₂ dans une proportion inférieure à 10% en pression partielle. A titre d'exemple non limitatif, l'atmosphère peut présenter un ratio POCl₃/O₂/N₂ compris entre 1/0,2/1 et 1/0/2.

L'étape b) est avantageusement exécutée dans un four de diffusion. Le substrat 1 peut être placé sur une nacelle en quartz ou en carbure de silicium. Les dopants de phosphore peuvent être obtenus à partir d'une source liquide. Le gaz vecteur (i.e. le diazote N₂) barbote dans POCl₃ sous forme liquide, de préférence à une température comprise entre 15°C et 20°C. La couche de PSG se forme autour du substrat 1 par adsorption.

### Recuit thermique

L'atmosphère inerte sous laquelle est exécutée l'étape c) est un mélange gazeux comportant avantageusement du diazote N₂ dans une proportion supérieure à 80% en pression partielle.

A titre d'exemple non limitatif, le recuit thermique appliqué lors de l'étape c) peut avoir une durée comprise entre 10 minutes et 200 minutes.

### Retrait de la couche de PSG

L'étape e) est avantageusement exécutée par un agent de gravure chimique. L'étape e) est avantageusement exécutée en plongeant le substrat 1 dans une solution d'acide fluorhydrique HF. La solution d'acide fluorhydrique présente avantageusement un ratio molaire H₂O/HF compris entre 20/1 et 50/1. Le substrat 1 est avantageusement plongé dans une telle solution pendant une durée comprise entre 10 secondes et 3 minutes.

### Couche antireflet

La couche antireflet 3 formée lors de l'étape d) est avantageusement réalisée dans un matériau formant une barrière à l'agent de gravure chimique pouvant être utilisé lors de l'étape e). Le matériau de la couche antireflet 3 peut former une barrière totale au sens où ledit matériau est résistant à l'agent de gravure chimique. Le matériau de la couche antireflet 3 peut former une barrière partielle au sens où ledit matériau est plus résistant à l'agent de gravure chimique que le PSG.

La couche antireflet 3 formée lors de l'étape d) est avantageusement en nitrure de silicium SiₓN_{y}. A titre de variantes, la couche antireflet 3 peut être réalisée dans au moins un matériau sélectionné parmi SiON, SiC, SiCN, SiO.

A titre d'exemple non limitatif, la couche antireflet 3 peut être formée par un dépôt chimique en phase vapeur assistée par plasma PECVD (« *Plasma-Enhanced Chemical Vapor Déposition* » en langue anglaise).

La couche antireflet 3 formée lors de l'étape d) présente préférentiellement une épaisseur comprise entre 30 nm et 110 nm.

### Polissage chimique

Le procédé comporte avantageusement une étape f) consistant à polir chimiquement la deuxième surface 11 du substrat 1, l'étape f) étant exécutée après l'étape e). L'étape f) est avantageusement exécutée en plongeant le substrat 1 dans un bain d'hydroxyde de potassium KOH.

L'étape f) est avantageusement suivie d'une étape f₂) consistant à plonger le substrat 1 dans un bain d'acide chlorhydrique HCl.

De manière alternative, l'étape f) peut être exécutée par un agent de gravure chimique tel que l'acide fluorhydrique HF, lorsque la couche antireflet 3 formée lors de l'étape d) est réalisée dans un matériau résistant à l'agent de gravure, par exemple un nitrure de silicium.

### Cellule photovoltaïque

Dans le cas d'une cellule photovoltaïque de type PERC, comme illustré à la figure 2f, le procédé comporte une étape g) consistant à former une couche de passivation 4 sur la deuxième surface 11 du substrat 1. L'étape g) est exécutée après l'étape f₂). Afin d'obtenir une cellule photovoltaïque, le procédé comporte préférentiellement des étapes, non illustrées, consistant à former des contacts électriques à la première surface 10 et à la deuxième surface 11 du substrat 1 (métallisation par sérigraphie à titre d'exemple).

Dans le cas d'une cellule photovoltaïque de type Al-BSF, le procédé comporte une étape g'), non illustrée, consistant à former une zone semi-conductrice (appelée BSF pour « *Back Surface Field* ») du même type de dopage que le substrat 1 à la deuxième surface 11 du substrat 1. L'étape g') est exécutée après l'étape f₂). Une couche d'aluminium est ensuite déposée sur la zone semi-conductrice BSF.

Il est à noter que le procédé selon l'invention peut s'appliquer à la fabrication d'autres types de cellules photovoltaïques, telles que les cellules photovoltaïques de type PERT («*Passivated Emitter*, *Rear Totally diffused*» en langue anglaise), PERL («*Passivated Emitter*, *Rear Locally diffused* » en langue anglaise) et IBC (« *Interdigitated Back Contact»* en langue anglaise).

Un objet de l'invention est un procédé de fabrication d'une cellule photovoltaïque, comportant les étapes successives :
a) prévoir un substrat 1 en silicium cristallin dopé de type n, comprenant :
   - une première surface 10 (dite face avant) et une deuxième surface 11 opposée (dite face arrière),
   - au moins une surface latérale 12 (quatre surfaces latérales 12 dans le cas d'un substrat 1 parallélépipédique, dont seulement deux surfaces latérales 12 sont visibles sur les figures) reliant les première et deuxième surfaces 10, 11 ;
b) former une couche de verre borosilicate 2 (BSG) sur les première et deuxième surfaces 10, 11 ainsi que sur les quatre surfaces latérales 12 du substrat 1 ; l'étape b) étant exécutée à une température comprise entre 700°C et 900°C, sous une atmosphère comportant un précurseur contenant du bore ;
c) appliquer un recuit thermique à la couche de verre borosilicate 2 formée à l'issue de l'étape b) ; l'étape c) étant exécutée à une température comprise entre 800°C et 1000°C sous une atmosphère inerte ;
d) former une couche antireflet 3 sur la couche de verre borosilicate 20 s'étendant sur la première surface 10 du substrat 1 ;
e) retirer la couche de verre borosilicate 21 s'étendant sur la deuxième surface 11 et sur les quatre surfaces latérales 12 du substrat 1, tout en conservant la couche de verre borosilicate 20 s'étendant sur la première surface 10 du substrat 1.

L'étape a) est illustrée aux figures la et 2a. L'étape b) est illustrée aux figures 1c et 2c. L'étape d) est illustrée aux figures 1d et 2d. L'étape e) est illustrée aux figures le et 2e.

Les caractéristiques techniques décrites ci-avant s'appliquent exceptées pour les points suivants :
(i) le substrat 1 est dopé de type n ;
(ii) l'étape b) est avantageusement exécutée de sorte que la couche de verre borosilicate (2) présente une épaisseur comprise entre 2 nm et 150 nm, de préférence comprise entre 2 nm et 10 nm ;
(iii) le précurseur contenant du bore peut être le BCl₃ ou le BBr₃ ;
(iv) la température à laquelle est exécutée l'étape c) est avantageusement comprise entre 850°C et 920°C.

L'invention ne se limite pas aux modes de réalisation exposés. L'homme du métier est mis à même de considérer leurs combinaisons techniquement opérantes, et de leur substituer des équivalents.

## Revendications

1. Procédé de fabrication d'une cellule photovoltaïque, comportant les étapes successives :
a) prévoir un substrat (1) en silicium cristallin dopé de type p, comprenant :
- une première surface (10) et une deuxième surface (11) opposée,
- au moins une surface latérale (12) reliant les première et deuxième surfaces (10, 11) ;
b) former une couche de verre phosphosilicate (2, 20, 21) sur les première et deuxième surfaces (10, 11) ainsi que sur ladite au moins une surface latérale (12) du substrat (1) ; l'étape b) étant exécutée à une température comprise entre 700°C et 900°C, sous une atmosphère comportant un précurseur contenant du phosphore ;
c) appliquer un recuit thermique à la couche de verre phosphosilicate (2, 20, 21) formée à l'issue de l'étape b) ; l'étape c) étant exécutée à une température comprise entre 850°C et 900°C sous une atmosphère inerte ;
d) former une couche antireflet (3) sur la couche de verre phosphosilicate (20) s'étendant sur la première surface (10) du substrat (1) ;
e) retirer la couche de verre phosphosilicate (21) s'étendant sur la deuxième surface (11) et sur ladite au moins une surface latérale (12) du substrat (1), tout en conservant la couche de verre phosphosilicate (20) s'étendant sur la première surface (10) du substrat (1).

2. Procédé de fabrication d'une cellule photovoltaïque, comportant les étapes successives :
a) prévoir un substrat (1) en silicium cristallin dopé de type n, comprenant :
- une première surface (10) et une deuxième surface (11) opposée,
- au moins une surface latérale (12) reliant les première et deuxième surfaces (10, 11) ;
b) former une couche de verre borosilicate (2, 20, 21) sur les première et deuxième surfaces (10, 11) ainsi que sur ladite au moins une surface latérale (12) du substrat (1) ; l'étape b) étant exécutée à une température comprise entre 700°C et 900°C, sous une atmosphère comportant un précurseur contenant du bore ;
c) appliquer un recuit thermique à la couche de verre borosilicate (2, 20, 21) formée à l'issue de l'étape b) ; l'étape c) étant exécutée à une température comprise entre 800°C et 1000°C sous une atmosphère inerte ;
d) former une couche antireflet (3) sur la couche de verre borosilicate (20) s'étendant sur la première surface (10) du substrat (1) ;
e) retirer la couche de verre borosilicate (21) s'étendant sur la deuxième surface (11) et sur ladite au moins une surface latérale (12) du substrat (1), tout en conservant la couche de verre borosilicate (20) s'étendant sur la première surface (10) du substrat (1).

3. Procédé selon la revendication 1, dans lequel l'étape b) est exécutée de sorte que la couche de verre phosphosilicate (2) présente une épaisseur comprise entre 2 nm et 50 nm, de préférence comprise entre 2 nm et 10 nm.

4. Procédé selon la revendication 2, dans lequel l'étape b) est exécutée de sorte que la couche de verre borosilicate (2) présente une épaisseur comprise entre 2 nm et 150 nm, de préférence comprise entre 2 nm et 10 nm.

5. Procédé selon la revendication 2 ou 4, dans lequel la température à laquelle est exécutée l'étape c) est comprise entre 850°C et 920°C.

6. Procédé selon l'une des revendications 1 à 5, dans lequel la température à laquelle est exécutée l'étape b) est comprise entre 750°C et 800°C.

7. Procédé selon l'une des revendications 1 à 6, dans lequel l'atmosphère inerte sous laquelle est exécutée l'étape c) est un mélange gazeux comportant du diazote N₂ dans une proportion supérieure à 80% en pression partielle.

8. Procédé selon l'une des revendications 1 à 7, dans lequel l'atmosphère sous laquelle est exécutée l'étape b) est un mélange gazeux comportant du dioxygène O₂ dans une proportion inférieure à 10% en pression partielle.

9. Procédé selon l'une des revendications 1 à 8, dans lequel l'étape e) est exécutée par un agent de gravure chimique, et la couche antireflet (3) formée lors de l'étape d) est réalisée dans un matériau formant une barrière à l'agent de gravure chimique.

10. Procédé selon l'une des revendications 1 à 9, dans lequel l'étape e) est exécutée en plongeant le substrat (1) dans une solution d'acide fluorhydrique HF, présentant un ratio molaire H₂O/HF compris entre 20/1 et 50/1, et pendant une durée comprise entre 10 secondes et 3 minutes.

11. Procédé selon l'une des revendications 1 à 10, dans lequel l'étape b) est exécutée dans un four de diffusion.

12. Procédé selon l'une des revendications 1 à 11, dans lequel la couche antireflet (3) formée lors de l'étape d) est en nitrure de silicium.

13. Procédé selon l'une des revendications 1 à 12, comportant une étape f) consistant à polir chimiquement la deuxième surface (11) du substrat (1), l'étape f) étant exécutée après l'étape e).

14. Procédé selon la revendication 13, dans lequel l'étape f) est exécutée par un agent de gravure chimique, de préférence l'acide fluorhydrique, et la couche antireflet (3) formée lors de l'étape d) est réalisée dans un matériau résistant à l'agent de gravure chimique, ledit matériau étant de préférence un nitrure de silicium.

15. Procédé selon la revendication 13, dans lequel l'étape f) est exécutée en plongeant le substrat (1) dans un bain d'hydroxyde de potassium KOH.

16. Procédé selon la revendication 15, dans lequel l'étape f) est suivie d'une étape consistant à plonger le substrat (1) dans un bain d'acide chlorhydrique HCl.
